(19) Europäisches Patentamt
European Patent Office
Office européen des brevets

(11) Publication number: **0 252 233 B1**

(12) # EUROPEAN PATENT SPECIFICATION

(45) Date of publication of patent specification: **26.06.91** (51) Int. Cl.$^5$: **G03F 7/085**

(21) Application number: **87105987.9**

(22) Date of filing: **24.04.87**

(54) **Process for improving the adhesion of non-polar photoresists to polar substrates.**

(30) Priority: **06.06.86 US 871348**

(43) Date of publication of application:
**13.01.88 Bulletin 88/02**

(45) Publication of the grant of the patent:
**26.06.91 Bulletin 91/26**

(84) Designated Contracting States:
**DE FR GB IT**

(56) References cited:
**GB-A- 2 139 777**
**GB-A- 2 167 686**
**US-A- 3 520 683**

**IBM TECHNICAL DISCLOSURE BULLETIN, vol. 20, no. 3, August 1977, page 1092, New York, US; K.L. MITTAL: "Antifogging material"**

**D.J. ELLIOTT: "Integrated circuit fabrication technology", 1982, pages 119-121, McGraw-Hill Book Co., New York, US**

(73) Proprietor: **International Business Machines Corporation**
**Old Orchard Road**
**Armonk, N.Y. 10504(US)**

(72) Inventor: **Linde, Harold George**
**RFD 1 Box 267**
**Richmond Vermont 05 477(US)**
Inventor: **Murphy, Elizabeth Theresa**
**P.O. Box 357**
**Richmond Vermont 05 477(US)**

(74) Representative: **Kreidler, Eva-Maria, Dr. rer. nat.**
**IBM Deutschland GmbH Patentwesen und Urheberrecht Schönaicher Strasse 220**
**W-7030 Böblingen(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 252 233 B1

## Description

The present invention relates to a process for improving the adhesion of non-polar photoresists to various polar substrates.

Silane adhesion promoters such as hexamethyldisilazane have been used to promote wetting and adhesion of conventional positive photoresists to various substrates. Such silane adhesion promoters are ineffective with non-polar photoresists as are contemplated per the present invention.

Ito et al, "A Sensitive Deep UV Resist System", SPE Regional Technical Conference, Ellenville, NY, November 1982, discloses deep UV (DUV) photoresist systems that have high sensitivity and do not suffer swelling during development which may be used either as positive or negative photoresists. The photoresist systems are based on formulations consisting of t-butyloxycarbonyl protected poly(vinylphenyl) and an onium salt sensitizer. The mechanism of such photoresist systems is described in, e.g., INTRODUCTION TO MICROLITHOGRAPHY, Willson, p. 153; 1983, ACS Symposium Report.

The basic mechanism involved in such deep UV (DUV) photoresist systems is also described in Frechet et al, "Poly(p-t-Butyloxycarbonyloxystyrene): A convenient precursor to p-hydroxystyrene resins", Accepted for Publication in Polymer (1982).

U.S. Patent 4,491,628 Ito et al discloses positive-and negative-working photoresists which are formulated from a polymer having recurrent pendant groups such as tert-butyl ester or tert-butyl carbonate groups. Such photoresists find particular use in the present invention and the entire disclosure of Ito et al is hereby incorporated by reference.

We have discovered that non-polar photoresists, such as polystyrene based photoresists, typically based on polystyrene carbonate (see U.S. Patent 4,491,628), show poor adhesion to various polar substrates as are used in the fabrication of semiconductor devices, for example, silicon wafers, etc., and exhibit adhesion loss during processing after photoresist development. This behavior is quite distinct from that of conventional novolac-based resists which are polar in nature.

As a consequence of this discovery, we investigated means to improve the adhesion of such non-polar photo-resists to polar substrates and discovered that by conditioning the surface of the polar substrate with an aqueous solution containing one or more non-polar organosilanes, adhesion of the non-polar photoresist to the polar substrate was dramatically improved, whereby adhesion loss was prevented and lithographic images developed in the non-polar photoresist could be taken through subsequent conventional wet chemical processing procedures without being stripped from the polar substrate until desired.

Document GB-A-2 167 686 discloses a process for increasing the adhesion of a negative photoresist to a siliceous substrate using an intermediary interlayer of a silane between the substrate and the resist polymer. To accomplish bonding, the silane coated substrate is heated, the resist polymer is then applied, and the resist polymer surface is irradiated to form an image and simultaneously bond the resist to the silane-coated surface.

The adhesion promoter of GB-A-2 167 686 acts at the substrate interface via silanol bonding but comprises an 'olefinic double bond' structure which cross-links to the negative resist material used in all embodiments of the above patent application (see page 14, lines 41 to 42, i. e. acryloyl, methacryloyl or vinyl; and page 11, lines 30 to 35, i.e. 3-methacryloxypropyl-tri-methoxysilane (MTS) as preferred silane. Negative acting resists, as those for use in GB-A-2 167 686, are chemically unsaturated. Exposure of the wafer substrate coated with a negative acting resist initiates a polymerization or cross-linking reaction which hardens the exposed areas thereof. The negative resist in unexposed areas is developed with an appropriate solvent.

The adhesion promoter of the present invention, while acting at the substrate via silanol bonding, is distinguished from the compounds of GB-A-2 167 686, in that it comprises a non-polar group R (alkyl or aryl, and preferably butyl) to provide compatibility with the non-polar resist for use in the present invention. The compound of the present invention can never have the olefinic double bond structure of GB-A-2 167 686. Therefore, the present invention is not anticipated by said prior art citation.

The major object of the present invention is to provide a process for improving the adhesion of non-polar photoresists to polar substrates, most typically polar substrates as are used in semiconductor manufacture, so that the same can be successfully processed without being stripped from the polar substrate prior to the desired time.

While the present invention will clearly find broader application, at present, due to the exacting requirements of semiconductor manufacture and the peculiar nature of photoresists such as polystyrene based photoresists which are non-polar in nature, pretreatment of polar substrates is necessary to insure that the photoresist will adhere to the polar substrate following lithographic development during wet processings as are conventionally used.

Hereafter the term "photoresist" in all instances, unless otherwise indicated, should be understood to refer to a non-polar photoresist.

Further, unless otherwise indicated, hereafter the term "substrate" is used for brevity to refer to a polar substrate.

Finally, when reference is made to an "organosilane", an "organosilane adhesion promoter" or like material, this is used to refer to a non-polar material.

Since the major factors of importance involved relate to the substrate treated, the nature of the organosilane adhesion promoter and the nature of the photoresist used, these will be discussed in detail.

In the present invention, the terms "polar" and "non-polar" are often used. These are not meant to reflect any critical "cut-off" value for photoresists, adhesion promoters or substrates per the present invention, rather, are meant to reflect the inherent incompatible nature of photoresists which are more non-polar than the substrates to which they are to be adhered or, from the opposite viewpoint, substrates which are more polar than the photoresists involved. Generally, the greater the difference in polarity between the photoresist and the substrate, generally the greater the adherence problems which will be encountered.

Based on our experience, once one appreciates the basic principles of the present invention, it does not involve undue effort to particularize any individual system and easily determine what materials will provide best results.

The three main factors to be considered are: 1) the substrate; 2) the organosilane and 3) the photoresist.

The substrate, fortunately or unfortunately, through contact with the environment, contains at least some silanol functionality at the surface thereof which is incompatible with the photoresist.

The organosiloxane adhesion promoter is hydrolyzed to also contain silanol functionality and, perhaps fortuitously, acts as a "bridge" between the substrate (polar) and photoresist (nonpolar) to insure adherence sufficient for conventional processing.

Generally speaking, the surfaces which find particular interest in the present invention are those which are used in the fabrication of semiconductor devices as are known in the art. For example, these would include silicon (with native oxide), silicon oxides as are typically encountered in the fabrication of semiconductor devices, most commonly silicon dioxide; silicon nitride ($Si_3N_4$) and oxidized silicon nitride (oxynitride).

The present invention also finds particular application with metal surfaces as are used in the fabrication of semiconductor devices, for example, silicon-aluminum-copper alloys which have a silicon rich oxide surface, e.g., those containing on the order of about 0.1~2 wt% silicon. Such alloys are typically vapor deposited and, by conventional techniques, result in a higher proportion of oxidized silicon on the surface thereof than in the interior thereof.

With all such materials, invariably there are some Si-OH groups (silanol functionality) present which result upon contact with the ambient. While in theory processing under vacuum or an inert atmosphere would avoid the formation of silanol functionality due to contact with oxygen and moisture in the air, as a practical matter this is impossible and, as a consequence, any silicon-based substrate as above-exemplified will contain at least surface silanol functionality. Variations in substrate stoichiometry and duration of contact with the ambient, produce surface inhomogeneties. As a result, the substrate is inherently poorly compatible with a relatively non-polar photoresist and adherence therebetween is unsatisfactory during subsequent processing.

The organosilane adhesion promoter or conditioner of the present invention is also relatively polar with reference to the substrate, but also has a non-polar nature similar to that of the photoresist.

As later explained in detail, the organosiloxane adhesion promoter contains at least one alkoxy or aryloxy moiety which, on hydrolysis, is converted to the silanol (Si-OH) moiety.

There is thus nothing "unique" about the substrates per the present invention, rather, they are conventional silicon-containing substrates as are widely used in the semiconductor industry which we have found to present an adherence problem with relatively non-polar photoresists due to inherent surface functionality, or the inevitable substrate reaction with oxygen and water in the air.

Processing in accordance with the present invention is directed to creating a uniform conditioned surface suitable for application of a non-polar photoresist, typically photoresists which are polystyrene based resist polymers of the t-butyloxycarbonylstyrene type. These are exemplified in the earlier identified publications and the Ito et al patent which are incorporated by reference.

Polystyrene based photoresist polymers used in the semiconductor arts can often be represented by general structural formula (I) given below:

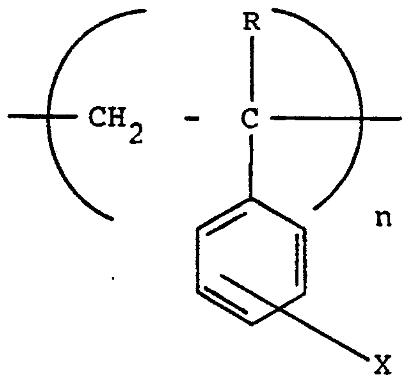

(I)

The repeating styrene moiety is easily recognized in the above formula; it serves as the backbone of the photoresist. The pendant group represented by X most usually is a group which can be represented by the formula:

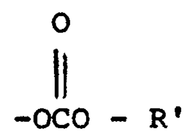

or

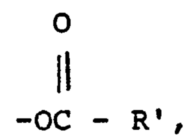

yielding what can be characterized as a carbonate or an ester.

R is generally hydrogen, alkyl or aryl, preferably hydrogen. We expect lower alkyl groups, e.g., methyl, ethyl and n- or i-propyl groups and aryl, e.g., phenyl groups, to also be useful.

The terminal R′ group in X can be the same as R, with the proviso R′ cannot be hydrogen, but R′ is preferably a straight or branched chain alkyl group with 3 to 5 carbon atoms, e.g., n-propyl, i-propyl or amyl, etc., with t-butyl being preferred.

Other useful photoresists are disclosed in the Ito et al patent.

Molecular weight is not especially limited, but we find best results with photoresists comprising a polystyrene-based material having a rather broad molecular weight distribution, e.g., with a dispersity value

$$\frac{(\text{weight average mol. wt.})}{\text{number average mol. wt.}}$$

of about 3 to about 8.

Weight average molecular weights generally run from about 20,000~200,000, which will set the bounds for n in formula (I).

Molecular weight is normally so high that the terminals of the polymer are not important and are generally rather simple, e.g., $-CH_3$, $-C_2H_5$, etc.

The photoresists can be either positive or negative in character, depending on the developer used. Development conditions are conventional and will be apparent to one skilled in the art from, e.g., the Ito et al patent and earlier mentioned references.

Polystyrene-based photoresists of the present invention are, for processing, merely exposed to DUV in a conventional manner and are then developed in a conventional manner to remove either exposed or unexposed areas depending on the character of the photoresist and no novelty is attached to these steps since the photoresists act in a conventional manner except we have solved the problem of unacceptable

adherence to polar substrates. The photoresist can be stripped from the substrate at any desired time using conventional techniques; again, the Ito et al patent and earlier mentioned references contain representative disclosure.

Having thus identified the general nature of the substrates which would be most typically treated in accordance with the present invention to "condition" the same to be receptive to a photoresist in accordance with the present invention, most typically a polystyrene based resist polymer of the t-butyloxycarbonyl type, applicants turn to the most essential feature of the present invention, the organosilanes which are used to condition the substrate to insure adherence to the photoresist so that the same may be lithographically processed in a conventional manner and then subjected to processings as are conventional in the art without stripping from the substrate until the desired time.

Useful adhesion promoters include non-polar organosilanes which initially contain alkoxy functionality and most preferably are those which have the structure represented by formula (II) below:

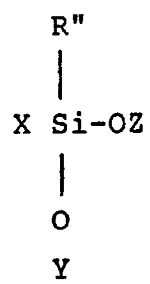

(II)

R″ is typically an alkyl group, which includes a substituted alkyl group, e.g., a fluoro-substituted alkyl group, or an aryl group. Representative examples of R include a propyl group, a butyl group, an amyl group, a cyclohexylmethyl group, a phenyl group, a benzyl group, a fluoroalkyl group, for example, trifluoropropyl, etc.

It is most preferred that R″ be butyl since this group is inert and does not enter into any inferring reactions during use. We expect alkyl groups such as alkyl groups with 1 to 24 carbon atoms to be useful R″ groups, e.g., octyl, nonadecyl, stearyl, etc., and expect trifluoro-substituted alkyl groups with 3 to 10 carbon atoms should also be useful R″ groups. If aryl, R″ is most preferably phenyl.

The major criterion which any R″ group should exhibit is that it should be inert during use and should not interfere with obtaining a homogeneous solution for application to the substrate.

X can be the same as R″; though X is selected from among the same classes as R", X and R″ need not be identical.

X can also be OY or OZ, as now explained; again, while X can be selected from the class of materials for OY and OZ, X, OY and OZ can be the same or different or two of these groups may be the same.

The essential moieties required in the organosilanes of the present invention are the Si-OY and Si-OZ moieties since these are at least in part hydrolyzed to the required silanol moiety.

Y is typically an alkyl group, for example, methyl, ethyl, or an acetoxy group, etc.

Z is also normally an alkyl group, for example, methyl, ethyl, or an acetoxy group, etc.

Organosilanes as are contemplated for use in the present invention to condition a substrate are commercially available or can be synthesized in a conventional manner. Many organosilanes are available from, e.g., Petrarch Systems, Inc., Bristol, PA.

The most preferred conditioners contemplated at present are butyltrimethoxysilane, phenyltrimethoxysilane and 3,3,3-trifluoropropyltrimethoxysilane.

Mixtures of various organosilanes could be used, if desired, at any proportion which would provide a homogeneous solution (needed for exacting applications), but at present we see no advantage to the use of such mixtures.

Adhesion promoters such as aminosilanes or polar cyanosilanes cause cracking during image development, and do not provide the results of the present invention.

The above description regarding the substrates used, organosilanes used and photoresists used sets the background of the present invention, and should enable one skilled in the art to practice the present invention without undue experimentation.

Typically, however, as will be appreciated by one skilled in the art of manufacturing semiconductor devices, when used in a processing environment the surfaces to be treated so as to condition the same to insure adequate adhesion of a non-polar photoresist such as a polystyrene based photoresist are precleaned with a conventional alcoholic or ester solvent and washed with deionized water. Pre-cleaning is simply to insure a clean surface on the substrate which does not carry any contaminants which might interfere with later semiconductor processing.

Substrates with oxide or silanol functionality are required in accordance with the present invention. These can result from conventional contact with the ambient, and will inherently result unless processing/storage is under vacuum or an inert atmosphere. Alternatively, this functionality can be enhanced with various conventional treatments as are used in semiconductor fabrication, e.g., by a conventional thermal or wet chemical oxidation techniques; for instance, oxygen reactive ion etching (RIE), aqueous peroxide ($H_2O_2$) etching, nitric acid etching, etc., as are well known in the art can be used. There is no special level of criticality to those treatments as all inherently increase the degree of oxygen functionality.

For a typical example of a substrate with enhanced oxide or silanol functionality, silicon nitride can be deposited by a conventional chemical vapor deposition (CVD). Upon contact with ambient air, it at least surface oxidizes, e.g., to a depth of 4~5 nm, unless specially stored.

It is conventional to clean such materials with conventional solutions such as Huang A (aqueous hydrogen peroxide/ammonia) or Huang B (aqueous hydrogen peroxide/hydrochloric acid); this again results in increased surface oxide or silanol (Si-OH) functionality.

After an optional, but preferred, conventional pre-cleaning treatment as mentioned above, the substrate is subjected to contact with one or more organosilanes in accordance with the present invention.

Following organosilane contact in accordance with the present invention, typically the substrate will be briefly rinsed, for example, in an aqueous/alcohol solution for about 30 seconds, spun dried or blow dried with nitrogen or compressed air, and optionally baked at about 80°C to about 150°C for about 1 to 10 minutes.

Post-treating is simply to remove solvent (spin drying, blow drying) with an optional bake to insure removal of any residual solvent which might be present and fix the adhesion promoter coating.

With respect to the actual conditioning of the present invention, most typically solutions of from about 0.01 to about 2% (by volume of the total solution; hereafter all percents, parts, or the like are by volume on the same basis unless otherwise indicated) organosilane(s) are prepared in a solvent. The solvent most typically is an alcohol/water mixture. Lower alcohols are most conveniently used, e.g., a lower alcohol with from 1 to 4 carbon atoms, and such alcohols most preferably include methanol, ethanol, the propanols and the butanols (isomers of any type can be used) including from about 7 to about 95% alcohol, balance water, based on total solution weight.

Most preferred solutions contain about equal ratios by weight of alcohol and water (except with the butanols where solubility may be limited to about 10% alcohol; in this instance less alcohol will be used) and most preferably include methanol or isopropanol due to commercial availability and ease of processing.

Of course, one can use mixtures of lower alcohols, if desired or necessary from some processing viewpoint.

In theory, we would prefer to use only water as a solvent for the organosilane(s) used. However, since a homogeneous solution is required for the exacting needs of semiconductor manufacture, and the organosilanes show limited solubility in water per se, normally we simply use an alcohol which is completely miscible with water and which is suitable for ease of processing, which insures solubility (solution) of the system.

Additional materials may be added to the solution, for example, ketones (such as acetone), esters (such as ethyl acetate), and ethers (such as diglyme, i.e.: bis(2-methyoxyethyl)ether

$$[CH_3 - O - CH_2 - CH_2]_2O,$$

etc. These materials serve a wetting function. One useful commercially available material is ArcosolV-PMAC (a tradename of ARCO Chemical Co., which is a division of Atlantic Richfield Co) (an alkyl acetate).

As earlier indicated, the alkoxysilane functionality of the organosilane must at least in part be hydrolyzed to silanol functionality per the present invention. The objective here is simply to permit sufficient silanol functionality to be present in the adhesion promoter to co-act with the silanol functionality in the substrate to insure good adherence therebetween without undue reaction between silanol groups in the adhesion promoter which "ties up" silanol moiety in the adhesion promoter with itself so it does not assist, we believe, in co-action with the substrate.

While we cannot quantify, due to current analytical procedures, the exact number of silanol groups necessary, we have found procedures which provide excellent results; these can be varied by one skilled in the art, with an empirical approach to easily determine acceptability or non-acceptability.

We currently use "natural" aging or "catalyzed" aging (hydrolysis). Either is perfectly acceptable.

The organosilane solution can be "naturally" aged before being used to permit hydrolysis of the alkoxysilane functionality to silanol functionality.

We have found that aging, for example, for 8 to 12 hours at room temperature is sufficient to provide the desired degree of hydrolysis of the alkoxysilane functionality to silanol functionality.

Simply permitting a plastic bottle of original aqueous/-alcohol organosilane solution to stand overnight at normal laboratory ambient thus provides an "aged" material with adequate siloxane functionality.

The hydrolysis can be rapidly catalyzed however, as now explained.

If desired, basic or acid catalysts may be added to the solution to hydrolyze the alkoxysilane groups present to the desired siloxane form.

Typical basic or acidic catalysts include amines such as diethylamine and acids such as acetic acid. The basic or acidic catalysts result in hydrolysis of the labile alkoxy functionality of the organosilanes to provide the desired siloxane functionality. Normally a small amount, e.g., on the order of about 0.01% of the total solution of a material such as ammonia or a lower alkyl (e.g., $C_1$-$C_4$ alkyl group) amine can be used or an alkyl carboxylic acid (for instance, formic acid, acetic acid, propionic acid, etc.) can be used to lower the pH to about 5. Acetic acid is most preferred to produce the desired degree of hydrolysis at a pH of about 5. For example, a drop or two of glacial acetic acid results in what we believe to be complete hydrolysis in about 10 minutes at ambient. In similar fashion, adding on the order of about 0.01% by weight of the total solution of a basic material hydrolyzes the alkoxysilanes in about 10 minutes.

Obviously, one skilled in the art can greatly vary the above procedures depending upon the use or non-use of a catalyst, the temperatures involved, etc.

Typically, the organosilane solution is prepared merely by mixing the appropriate constituents in any general fashion. For instance, one can add the desired amount of organosilane to the solvent system at room temperature and then blend the same to insure a homogeneous solution. There is no reason why higher or lower temperatures could not be used, but such do not appear to be necessary. The degree of agitation is not important so long as a homogeneous solution results.

The organosilane solution may, if desired, be filtered prior to use and if the materials are purchased from a commercial source, generally one might wish to filter through a 0.2 micron fluoropore filter to insure that no harmful materials are present. This is not, however, generally a problem.

Most typically, we have found that if one prepares a solution of about 0.1% organosilane in a 50/50 volume mixture of a lower alcohol and water and ages the same overnight, the conditioner of the present invention is ready for use.

The conditions of applying the adhesion promoter solution of the present invention are not overly important. Typically, it is applied under ambient temperature and pressure conditions using either a simple tank immersion or, in the case of wafers used in semiconductor device fabrication, the same can be applied on a conventional wafer spin table. The time of contact with the adhesion promoter solution immersion is not overly important, and at ambient temperature and pressure, normally we would find a contact time of from about 20 seconds to 10 minutes acceptable, with a time of between about 1 to about 2 minutes being preferred.

While we are not entirely sure about the mechanism involved in the present invention, it appears that the non-polar silane adhesion promoter results in a coupling reaction which changes the polar substrate surface functionality to a non-polar substrate functionality, essentially resulting in a hydrocarbon rich interface between the substrate and the photoresist. After initial wetting between the conditioned substrate and the photoresist, we believe, that the resulting conditioned surface probably maintains resist intimacy through substituent entanglement and hydrophobic interactions between the conditioned surface of the substrate and the photoresist.

Having thus generally described the invention, the following Examples are provided.

Example 1

For a typical working example, conventional wafer substrates of silicon nitride are immersed in a solution of concentrated nitric acid (ca. 70% aqueous) for 10 minutes at 85°C (a conventional treatment). Following rinsing in deionized water, the silicon nitride substrates are immersed in a solution containing 0.1% n-butytrimethoxysilane in methanol/water (1:1 volume; aged overnight at ambient conditions) for 2 minutes followed by a 30 second immersion rinse in isopropanol.

After drying in a conventional fashion, a styrene carbonate resist formulation of the type described in either the Ito et al or Frechet et al publications earlier cited can be spin applied to the silicon nitride wafer in a conventional fashion to any conventional thickness, e.g., on the order of about 1~5 μm; if desired, the wafer with photoresist can then be baked at, e.g., 100° C for 5 minutes to remove any residual solvent present, and then exposed to DUV, e.g., at about 190 300 nanometers, rebaked and then developed, e.g., for a negative photoresist, in xylene at ambient.

Exposure can then be conducted in a conventional manner, and development of the imaged patterns can be conducted in a conventional manner in a hydrocarbon solvent, for example, xylene, to thereby yield adherent image lines in the 0.5 μm range which can be subjected to any subsequent conventional wet processings without striping of the photoresist from the substrate. As explained in the Ito et al patent, after image wise exposure the photoresist is generally post-baked.

Example 2-5

The procedure of Examples 1-5 of U. S. Patent 4,491,628 Ito et al, earlier incorporated by reference, can, we believe, be followed exactly except for introducing the step of contact with an adhesion promoter per the present invention prior to photoresist coating (quartz used per Example 3 of Ito et al is, of course, $SiO_2$).

## Claims

1. Process for increasing the adhesion of a non-polar photoresist to a polar substrate which comprises contacting the substrate with a solution of a hydrolyzed non-polar organosilane containing alkoxy functionality in an amount effective and for a time effective to increase the adhesion of the non-polar photoresist to the polar substrate, and thereafter coating the polar substrate with the non-polar photoresist,

characterized in that

the substrate is coated with an aqueous solution of a hydrolyzed organosilane of the general formula:

$$\begin{array}{c} R'' \\ | \\ X - Si - OZ \\ | \\ O \\ Y. \end{array}$$

wherein:

R" is an alkyl group including a substituted alkyl group with 1 to 24 carbon atoms, or an aryl group;

X is an alkyl group, an aryl group or OY or OZ;

Y is an alkyl group or an acetoxy group; and

Z is an alkyl group or an acetoxy group;

and thereafter coated wit a photoresist comprising a polymer and and a photoinitiator, the polymer having the general structural formula:

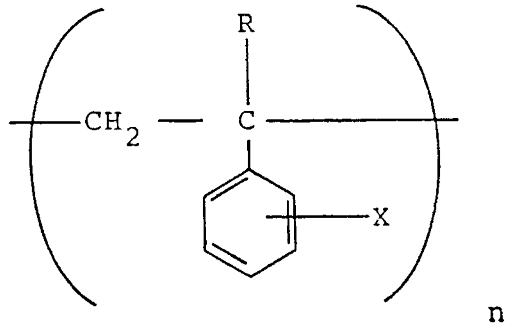

wherein:

R is hydrogen, a lower alkyl or an aryl group and X is OC(=O)OR' or OC=(O)-R', where R' has the same meaning as R, with the proviso R' cannot be hydrogen.

2. Process of claim 1, wherein the substrate is selected from the group consisting of silicon, silicon with native oxide, a silicon oxide, silicon nitride, silicon oxynitride and a silicon-aluminum-copper alloy.

3. Process of claim 1, wherein the aqueous solution of the non-polar organosilane comprises from about 0.01 to about 2% by volume of the non-polar organosilane, based on solution volume.

4. Process of claim 1, wherein R" in the general formula of the organosilane is a fluoro-substituted alkyl group, preferably trifluoropropyl.

5. Process of claim 1, wherein R" in the general formula of the organosilane is butyl or phenyl.

6. Process of one or several of claims 1 to 5, wherein the aqueous organosilane solution is allowed to age for 8 to 12 hours.

7. Process of one or several of claims 1 to 6, wherein the polar substrate is contacted with the aqueous organosilane solution for a time of between 20 seconds to 10 minutes, preferably for a time of between about 1 to 2 minutes.

8. Process of claim 1, wherein the polymer of the resist composition is a polystyrene based resist of the t-butyl oxycarbonyl type.

## Revendications

1. Procédé pour augmenter l'adhérence d'une photoréserve non polaire sur un substrat polaire qui comprend la mise en contact du substrat avec une solution d'un organosilane non polaire hydrolysé contenant la fonctionalité alcoxy en une quantité efficace et pendant une période de temps efficace pour augmenter l'adhérence de la photoréserve non polaire sur le substrat polaire et ensuite l'enduction du substrat polaire avec la photoréserve non polaire.
caractérisé en ce que le substrat est enduit d'une solution aqueuse d'un organosilane hydrolysé représenté par la formule générale:

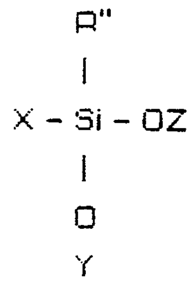

dans laquelle:

- R" est un groupe alkyle comprenant un groupe alkyle substitué ayant 1 à 24 atomes de carbone ou un groupe aryle;
- X est un groupe alkyle, aryle ou OY ou OZ;
- Y est un groupe alkyle ou acétoxy; et
- Z est un groupe alkyle ou acétoxy;

et revêtu ensuite d'une photoréserve comprenant un polymère et un photoinitiateur, le polymère ayant la formule générale suivante:

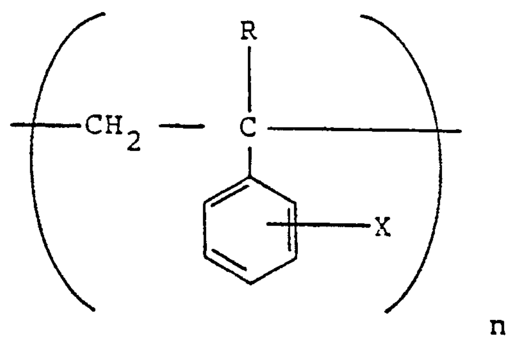

dans laquelle:

- R Est un atome d'hydrogène, un groupe alkyle inférieur ou un groupe aryle et
- X est un radical OC[=O]-R', ou OC[=O]-R', où R' a la même signification que R, à condition que R' ne soit pas un atome d'hydrogène.

2. Procédé suivant la revendication 1, caractérisé en ce que le substrat est choisi dans le groupe consistant en silicium, silicium avec oxyde natif, oxyde de silicium, nitrure de silicium, oxynitrure de silicium et alliage de silicium-aluminium-cuivre.

3. Procédé suivant la revendication 1, caractérisé en ce que la solution aqueuse de l'organosilane non polaire comprend d'environ 0,01 à 2% en volume de l'organosilane non polaire par rapport au volume de la solution.

4. Procédé suivant la revendication 1, caractérisé en ce que R" dans la formule générale de l'organosilane est un groupe alkyle substitué par du fluor, de préférence un groupe trifluoropropyle.

5. Procédé suivant la revendication 1, caractérisé en ce que R" dans la formule générale de l'organosilane est un groupe butyle ou phényle.

6. Procédé suivant l'une quelconque des revendications 1 à 5, caractérisé en ce que la solution aqueuse d'organosilane est laissée vieillir pendant 8 à 12 heures.

7. Procédé suivant l'une quelconque des revendications 1 à 6, caractérisé en ce que le substrat polaire est mis en contact avec la solution aqueuse d'organosilane pendant une période comprise entre 20 secondes et 10 minutes, de préférence pendant une période comprise entre environ 1 et 2 minutes.

8. Procédé suivant la revendication 1, caractérisé en ce que le polymère de la composition de photoréserve est une réserve à base de polystyrène du type t-butyl oxycarbonyle.

**Ansprüche**

1. Verfahren zur Haftungsverbesserung eines nichtpolaren Photolacks auf einem polaren Substrat, wobei das Substrat mit einer Lösung eines hydrolisierten nichtpolaren Organosilans mit Alkoxyfunktionalität in entsprechender Menge und für eine entsprechende Zeit in Verbindung gebracht wird, um die Haftung des nichtpolaren Photolacks auf dem polaren Substrat zu erhöhen, und das polare Substrat anschließend mit dem nichtpolaren Photolack beschichtet wird,

dadurch gekennzeichnet, daß

das Substrat mit einer wässrigen Lösung eines hydrolisierten Organosilans folgender allgemeiner Formel beschichtet wird:

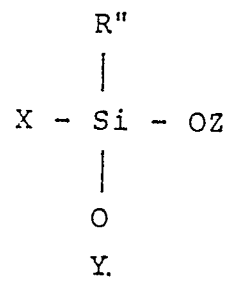

wobei es sich bei

R" um eine Alkylgruppe, die eine substituierte Alkylgruppe mit 1 bis 24 Kohlenstoffatomen enthält, oder eine Arylgruppe

X um eine Alkylgruppe, eine Arylgruppe oder OY oder OZ

Y um eine Alkylgruppe oder eine Acetoxygruppe und

Z um eine Alkylgruppe oder eine Acetoxygruppe handelt;

und anschließend eine Beschichtung mit einem Photolack erfolgt, der ein Polymer und einen Photoinitiator enthält, wobei das Polymer folgender allgemeiner Formel entspricht:

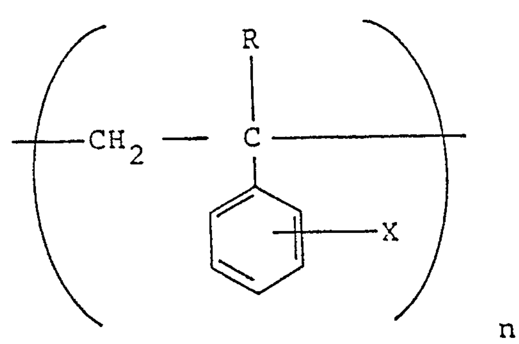

in der

R Wasserstoff, ein niedriges Alkyl oder eine Arylgruppe und X OC(=O)OR' oder OC=(O)-R' ist, wobei R' dieselbe Bedeutung wie R hat mit der Einschränkung, daß es sich bei R' nicht um Wasserstoff

handeln kann.

2. Verfahren nach Anspruch 1, wobei das Substrat aus der aus Silicium, Silicium mit nativem Oxid, einem Siliciumoxid, Siliciumnitrid, Siliciumoxidnitrid und einer Silicium/Aluminium/Kupferlegierung bestehenden Gruppe ausgewählt wird.

3. Verfahren nach Anspruch 1, wobei die wässrige Lösung des nichtpolaren Organosilans ca. 0,01 bis ca. 2 Volumenprozent des nichtpolaren Organosilans auf dem Lösungsvolumen basierend enthält.

4. Verfahren nach Anspruch 1, wobei es sich bei R" in der allgemeinen Formel des Organosilans um eine fluorsubstituierte Akylgruppe, vorzugsweise Trifluorpropyl, handelt.

5. Verfahren nach Anspruch 1, wobei es sich bei R" in der allgemeinen Formel des Organosilans um Butyl oder Phenyl handelt.

6. Verfahren nach einem oder mehreren der Ansprüche 1 bis 5, wobei die wässrige Organosilanlösung einem 8 bis 12-stündigen Alterungsprozess unterworfen wird.

7. Verfahren nach einem oder mehreren der Ansprüche 1 bis 6, wobei das polare Substrat mit der wässrigen Organosilanlösung 20 Sekunden bis 10 Minuten, vorzugsweise 1 bis 2 Minuten, lang in Verbindung gebracht wird.

8. Verfahren nach Anspruch 1, wobei es sich bei dem Polymer der Lackzusammensetzung um einen Lack auf Polystyrolbasis vom t-Butyloxycarbonyltyp handelt.